Europäisches Patentamt

European Patent Office

Office européen des brevets

(19)

(11) Numéro de publication : **0 298 855 B1**

(12)

# FASCICULE DE BREVET EUROPEEN

(45) Date de publication du fascicule du brevet :
02.01.92 Bulletin 92/01

(51) Int. Cl.⁵ : **H01R 9/09**, H01R 4/64

(21) Numéro de dépôt : **88401729.4**

(22) Date de dépôt : **04.07.88**

(54) Procédé de connexion entre un circuit imprimé et un substrat métallique.

(30) Priorité : **03.07.87 FR 8709459**

(43) Date de publication de la demande :
**11.01.89 Bulletin 89/02**

(45) Mention de la délivrance du brevet :
**02.01.92 Bulletin 92/01**

(84) Etats contractants désignés :
**BE DE ES GB IT NL SE**

(56) Documents cités :
**EP-A- 0 139 030**
**DE-A- 2 056 222**
**DE-A- 2 820 002**
**FR-A- 2 565 425**
**US-A- 2 038 913**

(73) Titulaire : **THOMSON GRAND PUBLIC**
**74, rue du Surmelin**
**F-75020 Paris (FR)**

(72) Inventeur : **Bercot, Jacques**
**Thomson-CSF SCPI-19, avenue de Messine**
**F-75008 Paris (FR)**

(74) Mandataire : **Chaverneff, Vladimir et al**
**THOMSON-CSF SCPI**
**F-92045 PARIS LA DEFENSE CEDEX 67 (FR)**

Jouve, 18, rue Saint-Denis, 75001 PARIS

## Description

La présente invention se rapporte aux procédés de connexion qui permettent de relier un circuit imprimé, notamment la masse de celui-ci, à un substrat métallique sur lequel est fixé ce circuit.

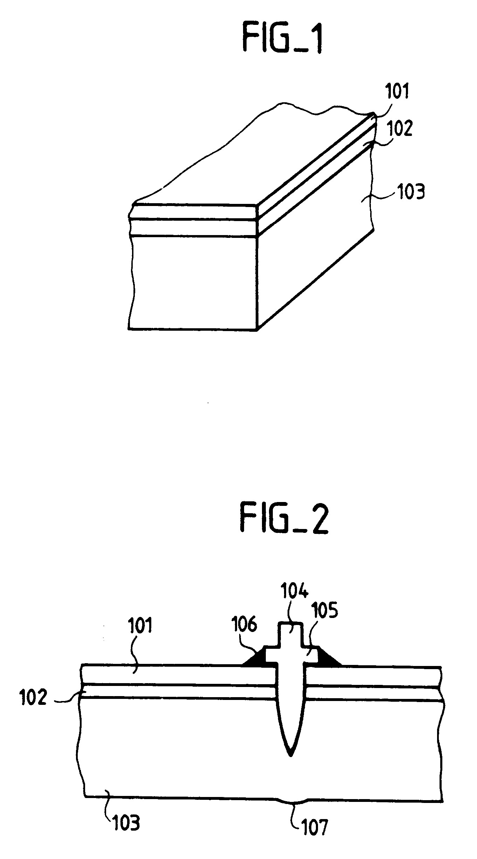

Pour certaines applications de grande série, telles que par exemple les allumages électroniques pour voiture, on est conduit à former des circuits imprimés en utilisant, comme représenté sur la figure 1, un film conducteur 101, sur lequel sera gravé le circuit imprimé, collé directement par l'intermédiaire d'un film adhésif isolant 102 sur un substrat épais 103, formé par exemple d'une plaque en alliage d'aluminium qui sert de radiateur au dispositif.

Dans une telle réalisation la capacité entre la masse du circuit imprimé et le radiateur est relativement importante en raison de la faible épaisseur du film isolant. Afin d'assurer l'immunité aux parasites du dispositif, il est nécessaire de prévoir un court-circuit entre cette masse et le substrat.

Il existe diverses solutions pour réaliser ce court-circuit, mais aucune ne donne réellement satisfaction :

On peut tout d'abord percer un trou dans l'ensemble, puis insérer en force un picot conducteur qui sera en contact aussi bien avec le circuit qu'avec le substrat. Pour maintenir l'étanchéité ce trou doit être borgne. Comme les picots disponibles couramment dans le commerce ont une précision sur le diamètre assez faible il est nécessaire d'avoir une précision importante sur le diamètre du trou, ce qui conduit à procéder à un alésage après le perçage. L'ensemble de ces opérations est coûteux et la réalisation est difficile à industrialiser.

On pourrait aussi procéder à un nickelage électrolytique de l'un des côtés du circuit, en le plongeant par la tranche dans un bain de nickelage sur une hauteur d'environ 1 cm. Cette solution est assez difficile à mettre en oeuvre pour que le nickelage établisse bien un pont par-dessus la couche isolante, et elle amène une perte importante de surface du circuit et donc un surcoût matière important.

On pourrait également faire une connexion avec un fil entre la tranche du circuit et le substrat, en soudant ce fil avec un laser. Cette solution est difficile à mettre en oeuvre, et encore plus à automatiser.

On pourrait enfin penser à utiliser un procédé de soudage, par points par exemple, entre la couche conductrice et le substrat, mais cela porterait l'ensemble, au moins de manière localisée, à une température d'environ 600°, tout à fait inacceptable en raison de la dégradation de l'isolant.

Pour pallier ces inconvénients, l'invention propose d'insérer à force, sans faire d'avant trou, une aiguille de petit diamètre qui viendra perforer la couche conductrice, la couche adhésive et le substrat sans déboucher à l'extérieur de celui-ci. Dans une réalisation préférée on appliquera avant l'insertion de l'aiguille un plot de pâte à souder destinée à être refondue ultérieurement.

De DE-A-2056222 et FR-A-2565425 est connu l'utilisation d'aiguilles insérés à force à travers une pluralité de substrats isolants superposés et pourvus de pistes conductrices de manière à assurer des liaisons électriques sélectives entre celles-ci.

D'autres caractéristiques et avantages de l'invention apparaîtront clairement dans la description suivante, faite en regard des figures annexées qui représentent :

— la figure 1 : une vue en perspective d'un circuit imprimé muni d'un substrat métallique, destiné à mettre en oeuvre l'invention ;

— la figure 2 : une coupe de ce même substrat muni d'une aiguille selon l'invention.

On a représenté sur la figure 2 une vue en coupe de l'ensemble de la figure 1, dans lequel on a inséré en force, sans percer d'avant trou, une aiguille 104 qui, après avoir perforé la masse du circuit 101, puis la couche adhésive 102, vient s'ancrer dans la masse du substrat 103.

Cette aiguille est par exemple en acier ou en laiton durci, d'un diamètre adéquat pour supporter la force d'insertion sans se briser tout en occupant une place aussi réduite que possible à la surface du circuit imprimé. Un diamètre d'environ 0,8 mm s'est révélé approprié dans la plupart des cas.

Pour insérer cette aiguille, on peut utiliser différentes solutions, par exemple un pistolet à air comprimé, ou un balancier qui vient frapper un piston. Ces appareils s'insèrent parfaitement dans une production en ligne sans préparation particulière du substrat.

Les dispersions sur la force d'insertion, dues tant à l'appareil à insérer qu'aux tolérances sur le diamètre et la forme de l'aiguille, peuvent provoquer des différences sensibles dans la profondeur d'enfoncement de l'aiguille. Pour éviter cet inconvénient il est utile de prévoir une collerette 105, située vers l'extrémité supérieure de l'aiguille et qui vient buter contre la surface du circuit imprimé 101 en arrêtant alors l'enfoncement de l'aiguille à une profondeur constante.

L'ancrage de l'aiguille dans le substrat 103 assure un contact électrique toujours satisfaisant. Par contre le contact électrique avec la masse du circuit 101 peut éventuellement varier dans le temps, notamment en fonction des variations de dilatation cycliques sous l'effet de l'échauffement du dispositif. Pour garder toujours un bon contact à ce niveau, il est utile de prévoir avant l'insertion de l'aiguille le dépôt à l'emplacement où s'effectue cette insertion d'un plot de pâte à souder 106. Les autres composants fixés sur le circuit imprimé sont du type à montage en surface, dont la connexion avec ce circuit est assurée par soudure, obtenue elle aussi à partir de pâte à souder. L'ensemble du dispositif est soumis à une opération de refusion qui assure la soudure des composants, et de l'aiguille par un point de soudure 106. Il est avantageux d'utiliser une aiguille dont la surface a été traitée, par étamage par exemple, pour améliorer le soudage.

Les essais ont montré que l'insertion d'une telle aiguille ne provoquait sur la surface extérieure du substrat 103 qu'une très légère déformation 107 ne présentant aucun inconvénient.

## Revendications

1. Procédé de connexion entre un circuit imprimé formé d'une couche conductrice gravée (101) et un substrat métallique (103) sur lequel cette couche conductrice est collée par une couche d'adhésif (102), caractérisé en ce que l'on insère en force une aiguille (104) qui vient percer directement les couches conductrice et adhésive pour s'ancrer dans le substrat sans déboucher à l'extérieur en établissant une connexion électrique entre la couche conductrice et le substrat.

2. Procédé selon la revendication 1, caractérisé en ce que l'aiguille (104) est munie d'une collerette (105) qui vient buter sur la surface extérieure du circuit imprimé (101) pour limiter l'enfoncement de l'aiguille à une longueur constante.

3. Procédé selon l'une quelconque des revendications 1 et 2, caractérisé en ce qu'avant d'enfoncer l'aiguille on applique un plot de pâte à souder à l'emplacement destiné à recevoir ladite aiguille.

4. Procédé selon l'une quelconque des revendications 1 à 3, caractérisé en ce que le diamètre de l'aiguille est de sensiblement 0,8 mm.

## Patentansprüche

1. Verfahren zur Herstellung einer Verbindung zwischen einer Druckschaltung, die in einer leitenden Schicht (101) durch Gravierung ausgebildet ist, und einem metallischen Substrat (103), auf das die leitende Schicht mit Hilfe einer Klebeschicht (102) aufgeklebt ist, dadurch gekennzeichnet, daß man eine Nadel (104) mit Gewalt unmittelbar durch die leitende Schicht und die Klebeschicht hindurchtreibt, die sich im Substrat verankert, ohne aus ihr hervorzustehen, wodurch eine elektrische Verbindung zwischen der leitenden Schicht und dem Substrat hergestellt wird.

2. Verfahren nach Anspruch 1, dadurch gekennzeichnet, daß die Nadel (104) einen Kragen (105) aufweist, der auf der äußeren Oberfläche des Druckschaltungskreises (101) zur Anlage kommt, um das Eindringen der Nadel auf eine konstante Länge zu begrenzen.

3. Verfahren nach einem beliebigen der Ansprüche 1 und 2, dadurch gekennzeichnet, daß vor dem Eintreiben der Nadel an der Stelle, an der die Nadel eingetrieben werden soll, ein Lötpastenpunkt aufgebracht wird.

4. Verfahren nach einem beliebigen der Ansprüche 1 bis 3, dadurch gekennzeichnet, daß der Durchmesser der Nadel etwa 0,8 mm beträgt.

## Claims

1. A method for establishing connection between a printed circuit constituted of an etched conducting layer (101) and a metal substrate (103) on which said conducting layer is glued by means of an adhesive layer (102), characterized in that a needle (104) is driven into the circuit, thus piercing directly the conducting and adhesive layers and anchoring itself in the substrate without projecting therefrom, thus establishing an electrical connection between the conducting layer and the substrate.

2. A method according to claim 1, characterized in that the needle (104) is provided with a collar (105) which bears on the outer surface of the printed circuit (101) in order to restrict the depth of needle insertion to a constant length.

3. A method according to any one of claims 1 and 2, characterized in that prior to driving the needle in, a stud of soldering paste is applied to the place intended to receive said needle.

4. A method according to any one of claims 1 to 3, characterized in that the needle diameter is substantially 0,8 mm.

# FIG_1

# FIG_2